(19) Europäisches Patentamt
European Patent Office
Office européen des brevets

(11) EP 4 502 666 A1

(12) EUROPEAN PATENT APPLICATION
published in accordance with Art. 153(4) EPC

(43) Date of publication:
**05.02.2025 Bulletin 2025/06**

(21) Application number: **23779188.4**

(22) Date of filing: **02.03.2023**

(51) International Patent Classification (IPC):
***G02B 1/18*** *(2015.01)* ***C23C 14/10*** *(2006.01)*
***G02B 1/115*** *(2015.01)* ***G02C 7/10*** *(2006.01)*

(52) Cooperative Patent Classification (CPC):
**C23C 14/10; G02B 1/115; G02B 1/18; G02C 7/10**

(86) International application number:
**PCT/JP2023/007736**

(87) International publication number:
**WO 2023/189159 (05.10.2023 Gazette 2023/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **31.03.2022 JP 2022059625**

(71) Applicant: **Hoya Lens Thailand Ltd.**
**Pathumthani 12130 (TH)**

(72) Inventors:
- **UEDA, Kyosuke**
  **Tokyo 160-8347 (JP)**
- **NOMURA, Takumi**
  **Tokyo 160-8347 (JP)**
- **IWATA, Nobuyoshi**
  **Tokyo 160-8347 (JP)**

(74) Representative: **Hoffmann Eitle**
**Patent- und Rechtsanwälte PartmbB**
**Arabellastraße 30**
**81925 München (DE)**

# (54) METHOD FOR PRODUCING SPECTACLE LENS

(57) Provided is a method for producing a spectacle lens with a base material and a metal atom-containing layer disposed on the base material, the method including: forming the metal atom-containing layer on the base material by electron beam vapor deposition of irradiating, with an electron beam, a vapor deposition source with a carrier that contains at least one granule selected from the group consisting of silicon dioxide ($SiO_2$), zirconium oxide (IV) ($ZrO_2$), and titanium oxide (IV) ($TiO_2$) and carries a metal particle containing at least one metal.

[Fig. 1]

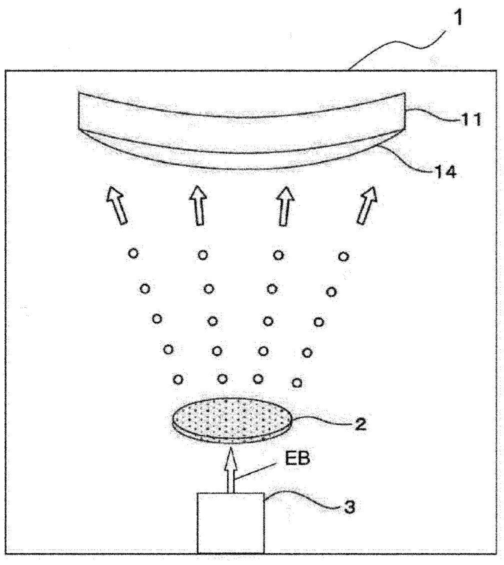


EP 4 502 666 A1

## Description

Technical Field

The present disclosure relates to a method for producing a spectacle lens.

Background Art

Metals are vapor-deposited on spectacle lenses using a vapor deposition source with a carrier carrying a metal particle as a sintered filter of stainless steel (SUS) containing Co, Ni, Fe, or the like or a vapor deposition source composed of a mixed material of $SiO_2$ and metal ion-carrying zeolite (for example, see PTL 1).

Citation List

Patent Literature

Patent Literature 1:Japanese Patent Application Publication No. 2018-12877

Summary of Invention

Technical Problem

However, when a vapor deposition source with a carrier carrying a metal particle as a SUS sintered filter is used, the following problems may occur: (i) the sintered filter wears out by electron beam (EB) irradiation, (ii) sintered filter components (for example, SUS) are vapor-deposited as impurities, (iii) because the metal-carrying amount per sintered filter is small, the antibacterial properties of a spectacle lens obtained by metal vapor deposition using one sintered filter are low, and the like.

Regarding the problem of (iii), it is possible to consider increasing the metal-carrying amount by thickening the sintered filter. However, even if the metal-carrying amount is increased by thickening the sintered filter, metal vapor deposition may not be sufficiently progressed due to limitations in the heating temperature of the sintered filter components or the like.

Furthermore, when a vapor deposition source composed of a mixture material of $SiO_2$ and metal ion-carrying zeolite is used, the refractive index of the formed "film composed of $SiO_2$ and metal" is higher than the refractive index of the "$SiO_2$ film". Thus, it is necessary to design the antireflection (AR) film newly, and the reflection characteristics change when the film is formed in the same way as existing products.

Under such circumstances, one aspect of the present disclosure has an object to provide a method for producing a spectacle lens capable of producing a spectacle lens with no adverse effects on reflective and transmissive characteristics and high antimicrobial performance.

Solution to Problem

The embodiments of the present disclosure relate to the following [1] to [9].

[1] A method for producing a spectacle lens with a base material and a metal atom-containing layer disposed on the base material, the method including: forming the metal atom-containing layer on the base material by electron beam vapor deposition of irradiating, with an electron beam, a vapor deposition source provided with a carrier that contains at least one granule selected from the group consisting of silicon dioxide ($SiO_2$), zirconium oxide (IV) ($ZrO_2$), and titanium oxide (IV) ($TiO_2$) and carries a metal particle containing at least one metal.

[2] The method for producing a spectacle lens according to [1], wherein the average particle diameter D50 of the granule is 0.1 to 5.0 mm.

[3] The method for producing a spectacle lens according to [1] or [2], wherein the granule is composed only of silicon dioxide ($SiO_2$).

[4] The method for producing a spectacle lens according to any one of [1] to [3], wherein the metal particle includes silver.

[5] The method for producing a spectacle lens according to [1] to [4], wherein the metal particle contains at least one selected from the group consisting of platinum, gold, palladium, mercury, cadmium, cobalt, nickel, copper, zinc, titanium, molybdenum, and tungsten.

[6] The method for producing a spectacle lens according to any one of [1] to [5], further including impregnating the

carrier with a liquid containing the metal particle and drying the carrier so that the carrier carries the metal particle.

[7] The method for producing a spectacle lens according to any one of [1] to [6], wherein the spectacle lens further has an anti-reflection film disposed on the base material, and the metal atom-containing layer is disposed on the anti-reflection film.

[8] The method for producing a spectacle lens according to any one of [1] to [6], wherein the spectacle lens further has an anti-reflection film disposed on the base material, the anti-reflection film is a laminated body with a lamination of a plurality of single layers, and the metal atom-containing layer is disposed between at least one pair of the single layers adjacent to each other.

[9] The method for producing a spectacle lens according to any one of [1] to [8], wherein the film thickness of the metal atom-containing layer is at most 5 nm.

Advantageous Effects of Invention

According to one aspect of this disclosure, a method for producing a spectacle lens capable of producing a spectacle lens with no adverse effects on reflective and transmissive characteristics and high antimicrobial performance can be provided.

Brief Description of Drawings

[Fig. 1]

Fig. 1 is a schematic diagram illustrating one example of a vacuum vapor deposition device with an electron gun.

Description of Embodiments

Hereinafter, embodiments and examples of the present disclosure will be described. The same reference symbols may be assigned to the same or corresponding parts, and the explanation thereof may not be repeated. When the number, amount, and the like are mentioned in the embodiments and examples explained below, the scope of the present disclosure is not necessarily limited to the number, amount, and the like unless otherwise noted. In the embodiments below, each constituent element is not necessarily essential to the embodiments and examples of the present disclosure unless otherwise noted.

[Method for Producing Spectacle Lens]

The method for producing a spectacle lens according to an embodiment of the present disclosure is a method for producing a spectacle lens with a base material and a metal atom-containing layer disposed on the base material, the method including forming the metal atom-containing layer on the base material by electron beam vapor deposition of irradiating, with an electron beam, a vapor deposition source provided with a carrier that contains at least one granule selected from the group consisting of silicon dioxide ($SiO_2$), zirconium oxide (IV) ($ZrO_2$), and titanium oxide (IV) ($TiO_2$) and carries a metal particle containing at least one metal.

Because the method for producing a spectacle lens according to an embodiment of the present disclosure uses a vapor deposition source having a carrier that contains at least one granule selected from the group consisting of silicon dioxide ($SiO_2$), zirconium oxide (IV) ($ZrO_2$), and titanium oxide (IV) ($TiO_2$) and carries a metal particle containing at least one metal, a spectacle lens with no adverse effects on reflective and transmissive characteristics and high antimicrobial performance can be produced.

<Base Material>

Examples of base materials may include a plastic lens base material, a glass lens base material, such as an inorganic glass lens base material, and the like. Among these, a plastic lens base material is preferable from the viewpoint that it is light-weight, hard to break, and easy to handle.

Examples of plastic lens base materials may include (meth)acrylic resins; styrene resins; polycarbonate resins; allyl resins; allyl carbonate resins such as diethylene glycol bis(allyl carbonate) resins (CR-39); vinyl resins; polyester resins; polyether resins; urethane resins obtained by reacting an isocyanate compound with a hydroxy compound such as diethylene glycol; thiourethane resins obtained by reacting an isocyanate compound with a polythiol compound, a cured product (generally referred to as a transparent resin) obtained by curing a curable composition containing a (thio)epoxy compound having at least one disulfide bond in the molecule, and the like.

As the base material, an undyed lens (colorless lens) may be used or a dyed lens (colored lens) may be used.

The refractive index of the base material is not particularly limited and, for example, about 1.60 to 1.75. The refractive index of the base material is not limited to the above range and may be within the above range or may be above or below the above range. In the present disclosure and the present description, the refractive index shall refer to a refractive

index for light at a wavelength of 500 nm.

In addition, the base material may be a lens having refractive power (so-called prescription lens) or a lens having no refractive power (so-called no-prescription lens).

The spectacle lens may be various lenses, such as a unifocal lens, a multifocal lens, or a progressive power lens. The type of the spectacle lens is determined by the surface shape of both sides of the base material. In addition, the surface of the base material may be any of a convex surface, a concave surface, or a flat surface. In a general base material and spectacle lens, the object-side surface is a convex surface, and the eyeball-side surface is a concave surface. However, the present disclosure is not limited thereto.

<Metal Atom-containing Layer>

In the method for producing a spectacle lens according to an embodiment of the present disclosure, a spectacle lens provided with a metal atom-containing layer disposed on the base material is produced.

Functions that the metal atom-containing layer may exhibit may be controlled depending on the type and/or combination of metals contained in the metal atom-containing layer. For example, when a metal atom-containing layer that can function as an antibacterial layer that contributes to impart a function that can inhibit the growth of bacteria (i.e., antimicrobial properties) to a spectacle lens, silver, for example, is mentioned as a metal contained in the metal atom-containing layer.

In one embodiment, the metal contained in the metal atom-containing layer may be at least one metal selected from the group consisting of platinum (Pt), gold (Au), palladium (Pd), mercury (Hg), cadmium (Cd), cobalt (Co), nickel (Ni), copper (Cu), zinc (Zn), titanium (Ti), molybdenum (Mo), and tungsten (W) .

In one embodiment, the metal atom-containing layer may contain silver as a first metal and at least one metal other than silver as a second metal.

The second metal is at least one metal selected from the group consisting of platinum, gold, palladium, mercury, cadmium, cobalt, nickel, copper, zinc, titanium, molybdenum, and tungsten, preferably at least one metal selected from the group consisting of platinum, palladium, and gold, and platinum is more preferable.

The metal atom-containing layer may contain only one type of metal selected from the above group as a second metal in one embodiment and may contain two or more types of them in another embodiment.

Examples of the existence form of the metal in the metal atom-containing layer may include a form of a simple metal, a form of an alloy, a form of an inorganic compound, such as a metal oxide, a form of an organic compound, a form of a metal ion, and the like.

In the metal atom-containing layer, for example, silver can exist in a plurality of existence forms. The same applies to other metals.

The present inventors infer that at least part of silver can be ionized by oxidation to exhibit antibacterial properties, which contributes to the metal atom-containing layer being able to function as an antibacterial layer.

In addition, the present inventors infer that in the metal atom-containing layer that contains at least one second metal selected from the above group, in addition to silver, the selection of the above metal having an effect of controlling the progress of the oxidation of silver as the second metal contributes to enhance the durability of antibacterial properties.

However, the present disclosure is not limited by the inference described in the present description.

The metal atom-containing layer may be a metal-containing inorganic layer in one embodiment. In the present disclosure and the present description, an "inorganic layer" is a layer containing an inorganic substance and is preferably a layer containing an inorganic substance as a main component. The "main component" herein refers to a component that is most abundant in the layer, and is a component contained in an amount of normally about 50% to 100% by mass, preferably about 90% to 100% by mass with respect to the mass of the layer. The same applies to the main components described below.

The metal-containing inorganic layer may contain the metal mentioned above in the form of a simple metal, an alloy, or an inorganic substance, such as an inorganic compound. An inorganic substance is preferable as a component constituting a layer formed on a spectacle lens that is often processed with heat in the production process because an inorganic substance is highly stable to heat and has a tendency to resist thermal decomposition.

<Electron Beam Vapor Deposition>

In the production method described above, the metal atom-containing layer is formed by electron beam vapor deposition of irradiating, with an electron beam, a vapor deposition source with a carrier that contains at least one granule selected from the group consisting of silicon dioxide ($SiO_2$), zirconium oxide (IV) ($ZrO_2$), and titanium oxide (IV) ($TiO_2$) and carries a metal particle containing at least one metal. A thin film metal atom-containing layer can be easily formed by adopting such a film-forming method. The ability to form a thin film layer with good uniformity of thickness is preferable from the viewpoint of improving the functions exhibited by the layer or sustaining the functions. From this point, the metal atom-containing layer is formed by adopting the above film-forming method.

Examples of the existence form of metal in the metal particle may include a form of a simple metal, a form of an alloy, a form of an inorganic compound, such as a metal oxide, a form of an organic compound, a form of a metal ion, and the like.

Examples of metals contained in the metal particle may include silver.

In one embodiment, the metal contained in the metal particle may be at least one metal selected from the group consisting of platinum (Pt), gold (Au), palladium (Pd), mercury (Hg), cadmium (Cd), cobalt (Co), nickel (Ni), copper (Cu), zinc (Zn), titanium (Ti), molybdenum (Mo), and tungsten (W) .

In one embodiment, the metal particle may contain silver as a first metal and at least one metal other than silver as a second metal.

The second metal is at least one metal selected from the group consisting of platinum, gold, palladium, mercury, cadmium, cobalt, nickel, copper, zinc, titanium, molybdenum, and tungsten, preferably at least one metal selected from the group consisting of platinum, palladium, and gold, and platinum is more preferable.

The metal particle may contain only one type of metal selected from the above group as a second metal in one embodiment and may contain two or more types of them in another embodiment.

Electron beam vapor deposition methods are film-forming methods including irradiating a vapor deposition source with an electron beam from an electron gun in a vacuum to heat and vaporize a vapor deposition material contained in the vapor deposition source and deposit the vapor deposition material on an object to be deposited to form a vapor deposition film.

In contrast, vapor deposition methods may also include a method (hereinafter referred to as a "heating vapor deposition method") in which a vapor deposition material is heated and vaporized by heating the internal atmosphere of a device using a heating unit (a heater, etc.) disposed in the vapor deposition device. In the heating vapor deposition method, an object to be deposited placed in a vapor deposition device is also heated. Here, plastic lens base materials are preferable as the base material for spectacle lenses, but plastic lens base materials may deform when exposed to high temperatures. Thus, if a film is deposited on a plastic lens base material by adopting a heating deposition method, the heating temperature must be set in consideration of suppressing the deformation of the plastic lens base material. Because the heating temperature thus set may not always be appropriate for the vapor deposition material, there may be a case where it is not easy to form a thin vapor deposition film with excellent uniformity in film thickness. Furthermore, it may be necessary to select a vapor deposition material that can be vaporized at the set heating temperature, and the types of vapor deposition materials that can be used may be limited.

In contrast, a vapor deposition film may be formed by an electron beam vapor deposition method without exposing an object to be deposited to high temperatures as in the heating vapor deposition method mentioned above because a vapor deposition material is heated by irradiating a vapor deposition source with an electron beam.

Hereinafter, the embodiments of the method for forming the metal atom-containing layer using an electron beam vapor deposition method will be described. However, the present disclosure is not limited to the embodiments below.

As vapor deposition sources, a vapor deposition source with a carrier that contains at least one granule selected from the group consisting of silicon dioxide ($SiO_2$), zirconium oxide (IV) ($ZrO_2$), and titanium oxide (IV) ($TiO_2$), preferably a granule consisting only of silicon dioxide ($SiO_2$), particularly preferably a granule consisting only of amorphous silicon dioxide ($SiO_2$), and carries a metal particle containing at least one metal is used. The term "amorphous" herein means a state of a substance without crystal structures.

The average particle diameter D50 of the granule is not particularly limited, and in view of suppressing the evaporation or dissolution of the granule, D50 is preferably at least 0.1 mm, more preferably at least 0.2 mm, and particularly preferably at least 0.5 mm. In contrast, from the viewpoint of efficiently loading the metal particle, D50 is preferably at most 5.0 mm, more preferably at most 2.0 mm, and particularly preferably at most 1.0 mm.

The average particle diameter D50 of the granule is a particle diameter at the point of 50% in a cumulative particle size distribution on a volume basis determined by, for example, laser diffraction measurement of a sample.

For example, when the metal contained in the metal atom-containing layer is a combination of a first metal (silver) and at least one second metal, as described previously, the vapor deposition source may be prepared, for example, by the following method.

A liquid containing particles of silver (silver particles) as a first metal (hereinafter also referred to as a "first metal particle-containing liquid") is prepared. Such a first metal particle-containing liquid may be, for example, an aqueous dispersion liquid of silver particles. The concentration (content) of silver particles in the first metal particle-containing liquid may be, for example, within the range of 1000 to 10000 ppm. In the present disclosure and this description, "ppm" is on a mass basis.

Separately from the above first metal particle-containing liquid, a liquid containing at least one type of second metal particles (hereinafter also referred to as a "second metal particle-containing liquid") is prepared. Such a second metal particle-containing liquid may be, for example, an aqueous dispersion liquid of the second metal particles. Furthermore, as the second metal particle-containing liquid, only one type of a second metal particle-containing liquid

that contains at least one type of second metal particles may be used, or two or more types of second metal particle-containing liquids that contain at least one type of second metal particles may be used. In both cases, the concentration (content) of the second metal particles in the second metal particle-containing liquid may be, for example, within the range of 1000 to 10000 ppm. When the second metal particle-containing liquid contains two or more types of second metal particles, the concentration (content) mentioned above shall refer to the concentration (content) of the total of those two or more types of second metal particles.

As each metal particle-containing liquid, for example, a commercial product that is commercially available as an aqueous dispersion liquid of a metal particle may be used as it is, or a commercial product may be used after dilution.

After the solution is prepared in this manner, a carrier that contains the granule mentioned above is impregnated with the metal particle-containing liquid. The carrier may be separately or simultaneously impregnated with plural types of the metal particle-containing liquid mentioned above, or the carrier may be impregnated with a mixed liquid in which plural types of metal particle-containing liquids are mixed. The liquid amount of the first metal particle-containing liquid to be impregnated into a carrier may be, for example, within the range of 0.1 to 5.0 mL. The liquid amount of the second metal particle-containing liquid to be impregnated into a carrier may be, for example, within the range of 0.1 to 5.0 mL. The liquid amount of the second metal particle-containing liquid in relation to that of the first metal particle-containing liquid may be within the range of 0.1 to 5 times. Here, when two or more types of second metal particle-containing liquids are used as the second metal particle-containing liquid, the liquid amount mentioned above shall refer to the liquid amount of the total of those two or more types of second metal particle-containing liquids.

Examples of methods for impregnating a carrier with a metal particle-containing liquid may include a method for injecting or spraying a metal particle-containing liquid into a carrier, a method for immersing a carrier in a metal particle-containing liquid, and the like.

By impregnating a carrier made of a granule with the above metal particle-containing liquid and then performing a drying process, the solvent component (water content) in the metal particle-containing liquid evaporates, and the metal particle is retained in the carrier made of the granule.

The particle diameter of each metal particle described above is preferably 0.1 to 10 nm, more preferably 1 to 7 nm, and particularly preferably 2 to 5 nm from the viewpoint that the vapor deposition source can be easily vaporized by irradiation with an electron beam.

The electron beam vapor deposition may be performed in a vacuum vapor deposition device provided with an electron gun. Fig. 1 shows a schematic diagram of one example of such a vacuum vapor deposition device.

In the interior part (normally referred to as a "vacuum chamber") of the vacuum vapor deposition device 1 illustrated in Fig. 1, an object 11 to be deposited and an electron gun 3 are arranged to face each other while sandwiching a vapor deposition source 2. The surface on the vapor deposition source of the object 11 to be deposited is the surface of a part on which a metal atom-containing layer 14 is formed. Such a surface is a base material surface if the metal atom-containing layer is directly formed on the base material surface and is a surface of a layer formed on the base material if the metal atom-containing layer is laminated on the layer formed on the surface. The electron beam EB may be generated by applying a heating current to the filament provided in the electron gun 3. The heating current mentioned above is set depending on the constitution of the electron gun used, the type of vapor deposition material, and the like. Furthermore, the irradiation condition, such as the electron beam irradiation time, is set to the desired film thickness and the like. Irradiation of the vapor deposition source 2 with an electron beam EB generated from the electron gun 3 heats and vaporizes the vapor deposition material contained in the vapor deposition source 2, and the vapor deposition material is deposited on the surface of the object 11 to be film-deposited to form the metal atom-containing layer 14. When a vapor deposition source in which a carrier carries first metal particles and second metal particles, as described previously, is used as the vapor deposition source 2, the metal atom-containing layer 14 may be formed on the object 11 to be deposited as a vapor deposition film containing those metals by heating and vaporizing first metal particles and second metal particles, which are vapor deposition materials by irradiation with an electron beam. The inside of the vacuum chamber is, for example, an atmospheric atmosphere, and the internal pressure should be the pressure at which vacuum vapor deposition is generally performed and may be, for example, at most $2 \times 10^{-2}$ Pa. The electron beam vapor deposition process is performed one or more times and may be performed two or more times using the same type or different types of vapor deposition sources 2. For example, a metal atom-containing layer 14 with a larger film thickness can be formed by performing an electron beam vapor deposition process two or more times using the same type or different types of vapor deposition sources 2.

In the above, a case of forming a metal atom-containing layer that contains two or more metals is described as an example, but the above metal atom-containing layer may contain only one type of metal in one embodiment. The formation of such a metal atom-containing layer can also be referred to the above description.

As described previously, it is preferable that the presence of the functional layer has little effect on the reflective and/or transmissive properties of the spectacle lens from the viewpoint of enabling the production of a spectacle lens with a functional layer without changing or without greatly changing the optical design of the existing products. From this point, the film thickness of the metal atom-containing layer is preferably thin, and the film thickness of the metal atom-containing layer is preferably at most 5 nm, more preferably at most 4 nm, and particularly preferably at most 3 nm (for example, at

least 1 nm and at most 3 nm). In the present disclosure and the present description, the film thickness of the metal atom-containing layer is a physical film thickness. The same applies to various thicknesses in the present disclosure and the present description. For the spectacle lens obtained by laminating two or more layers of the same type or different types of metal atom-containing layers by two or more times of film formation processes, the film thickness of the metal atom-containing layer shall refer to the total thickness of those two or more layers. As explained previously, a vapor deposition film that is a thin film with a film thickness within the above range and has excellent film thickness uniformity can be formed by forming the metal atom-containing layer by electron beam vapor deposition method. The film thickness of each layer and the thickness of the base material included in the spectacle lens, such as the metal atom-containing layer, may be determined, for example, by cross-sectional observation using a scanning electron microscope (SEM).

The metal atom-containing layer described above may be directly formed on the base material surface of a spectacle lens in one embodiment or may be formed indirectly via one or more other layers on the lens base material surface in another embodiment. The following is a description of the various layers that can be included in spectacle lenses produced by the above production method.

<Spectacle Lens>

In one embodiment, the spectacle lens further has an anti-reflection film disposed on the base material, and the metal atom-containing layer is disposed on the anti-reflection film. When the anti-reflection film is a multilayer film, the metal atom-containing layer is disposed above the anti-reflection layer at the position farthest from the base material.

In another embodiment, the spectacle lens further has an anti-reflection film disposed on the base material. The anti-reflection film is a laminated body with a lamination of a plurality of single layers, and the metal atom-containing layer is located between at least one pair of single layers adjacent to each other. When the anti-reflection film is a multilayer film, the metal atom-containing layer is disposed below the anti-reflection layer at the position farthest from the base material.

<<Layer that Spectacle Lens Can Include>>

(Inorganic Layer)

The spectacle lens may have an inorganic layer on the base material. In the present disclosure and the present description, an "inorganic layer" is a layer containing an inorganic substance, as described previously, and is preferably a layer containing an inorganic substance as a main component. The main component is as described previously. The metal atom-containing layer can be a layer that is directly laminated on the surface of the base material or may be a layer that is indirectly laminated via one or more other layers on the surface of the base material. Examples of other layers may include known layers, such as a cured layer of a curable composition, which is generally called a hard coat layer, and a primer layer provided for improving adhesion properties. The types and film thicknesses of these layers are not particularly limited and can be determined according to desired functions and optical properties for the spectacle lens.

The thickness of the hard coat layer is preferably 0.1 to 10 $\mu$m, more preferably 0.5 to 7 $\mu$m, and particularly preferably 1 to 5 $\mu$m.

In one embodiment, the inorganic layer may be a multilayer film composed of two or more inorganic layers. When the inorganic layer is a multilayer film, the metal atom-containing layer may be formed above or below the uppermost inorganic layer of this multilayer film (that is, an inorganic layer at the position farthest from the base material). Examples of such a multilayer film may include a multilayer film including at least one high-refractive-index layer and at least one low-refractive-index layer. Such a multilayer film may be an antireflection film having the property of preventing the reflection of light having a specific wavelength or light within a specific wavelength range or a reflection film having the property of reflecting light having a specific wavelength or light within a specific wavelength range. In the present disclosure and the present description, "high" and "low" for the "high refractive index" and "low refractive index" are relative expressions. That is, the high-refractive-index layer is a layer having a higher refractive index than the low-refractive-index layer included in the same multilayer film. In other words, the low-refractive-index layer refers to a layer having a lower refractive index than the high-refractive-index layer included in the same multilayer film. The refractive index of the high-refractive-index material constituting the high-refractive-index layer is, for example, at least 1.60 (for example, within the range of 1.60 to 2.40), and the refractive index of the low-refractive-index material constituting the low-refractive-index layer is, for example, at most 1.59 (for example, within the range of 1.37 to 1.59). However, as mentioned above, the terms "high" and "low" of the phrases of high refractive index and low refractive index indicate relative magnitude. Therefore, the refractive indexes of the high-refractive-index material and the low-refractive-index material are not limited to the ranges mentioned above.

Specific examples of high-refractive-index materials for forming a high-refractive-index layer may include at least one oxide selected from the group consisting of zirconium oxide (for example, $ZrO_2$), tantalum oxide (for example, $Ta_2O_5$), titanium oxide (for example, $TiO_2$), aluminum oxide (for example, $Al_2O_3$), yttrium oxide (for example, $Y_2O_3$), hafnium oxide

(for example, $HfO_2$), and niobium oxide (for example, $Nb_2O_5$).

Meanwhile, examples of low-refractive-index materials for forming a low-refractive-index layer may include at least one oxide or fluoride selected from the group consisting of silicon oxide (for example, $SiO_2$), magnesium fluoride (for example, $MgF_2$) and barium fluoride (for example, $BaF_2$). In these examples, the oxides and fluorides are indicated by stoichiometric composition, but the oxides and fluorides including oxygen or fluoride in an amount less than or more than the stoichiometric amount may also be used for the high-refractive-index material or the low-refractive-index material.

Preferably, the high-refractive-index layer is a film containing a high-refractive-index material as a main component, and the low-refractive-index layer is a film containing a low-refractive-index material as a main component. Such a film (for example, a vapor deposition film) may be formed by the film formation using a film formation material (for example, a vapor deposition material) containing the high-refractive-index material or the low-refractive-index material as a main component. Films and film formation materials may contain impurities that are inevitably mixed and may contain other components, for example, other inorganic substances and known additive components that assist the film formation, to the extent that functions that the main component exhibits are not impaired. The film formation can be performed by a known film-forming method, and in view of the ease of film formation, the film formation is preferably performed by vapor deposition and more preferably performed by vacuum vapor deposition. The antireflection film is, for example, a multilayer film in which a total of 3 to 10 layers of high-refractive-index layers and low-refractive-index layers are alternately laminated. The film thickness of the high-refractive-index layer and the film thickness of the low-refractive-index layer can be determined according to the layer structure. Specifically, a combination of layers included in the multilayer film and the film thickness of each layer can be determined by an optical design simulation using a known technique based on the refractive index of the film formation material for forming a high-refractive-index layer and a low-refractive-index layer and the desired reflection property and transmission property to be brought to the spectacle lens by forming the multilayer film. In addition, the multilayer film may include, at any position, a layer containing a conductive oxide as a main component (conductive oxide layer), preferably one or more layers of vapor deposition films of a conductive oxide formed by vapor deposition using a vapor deposition material containing a conductive oxide as a main component.

The thickness of the multilayer film is preferably 100 to 1000 nm, more preferably 200 to 800 nm, and particularly preferably 300 to 700 nm.

In one embodiment, the spectacle lens produced by the production method may have the metal atom-containing layer mentioned above on the surface of the inorganic layer. For example, the metal atom-containing layer can be a layer that is directly laminated on the surface of the inorganic layer or a layer that is indirectly laminated via one or more other layers on the surface of the inorganic layer. For the other layers, the previous description can be referred to.

(Water-Repellent Layer)

The spectacle lens produced by the production method may have a water-repellent layer. In the present disclosure and the present description, the "water-repellent layer" shall refer to a layer that contributes to the surface of the spectacle lens exhibiting water repellency or contributes to exhibiting better water repellency than when this layer is absent. In one embodiment, the spectacle lens produced by the production method may have a water-repellent layer on the surface of the metal atom-containing layer. For example, the water-repellent layer may be a layer that is directly laminated on the surface of the metal atom-containing layer or a layer that is indirectly laminated via one or more other layers on the surface of the metal atom-containing layer. For the other layers, the above description can be referred to.

The water-repellent layer may be laminated on the metal atom-containing layer by a film formation process using a film-forming material capable of functioning as a water-repellent agent. As the film-forming method, film-forming methods selected from the group consisting of dry film-forming methods and wet film-forming methods may be mentioned. Examples of dry film-forming methods may include a physical vapor deposition method and a chemical vapor deposition method, and examples of wet film-forming methods may include a coating method and the like. Examples of physical vapor deposition methods may include a vapor deposition method, a sputtering method, and the like. Among these, vapor deposition methods are preferable.

The water-repellent layer may be a fluorine-based organic layer in one embodiment. Here, the term "based" is used to mean "containing". In the present invention and the present description, an "organic layer" is a layer containing an organic substance and is preferably a layer containing an organic substance as a main component. The main component is as described previously.

The fluorine-based organic layer may be laminated on the metal atom-containing layer by performing a film-formation process using a fluorine-based organic substance as a film forming material. As a preferable film-forming method for forming a fluorine-based organic layer, a dry film-forming method may be mentioned, and a vapor deposition method is more preferred. Because fluorine-based organic substances tend to have lower boiling points than the vapor deposition materials that may be used to form the metal atom-containing layers described previously, the use of the heat vapor deposition method is also preferable. By impregnating a carrier with a liquid containing a fluorine-based organic substance (for example, dispersion) and then performing a drying process, a vapor deposition source in which the carrier

carries a fluorine-based organic substance may be formed. For the method for preparing the vapor deposition source, the previous description of the formation of metal atom-containing layers can also be referred to as appropriate.

As an example of the fluorine-based organic compound, m-xylene hexafluoride ($C_6H_4(CF_3)_2$) or the like may be mentioned.

In addition, as the fluorine-based organic compound, for example, a fluorine-based organic silane compound represented by the following general formula (1) may be mentioned.

[C1]

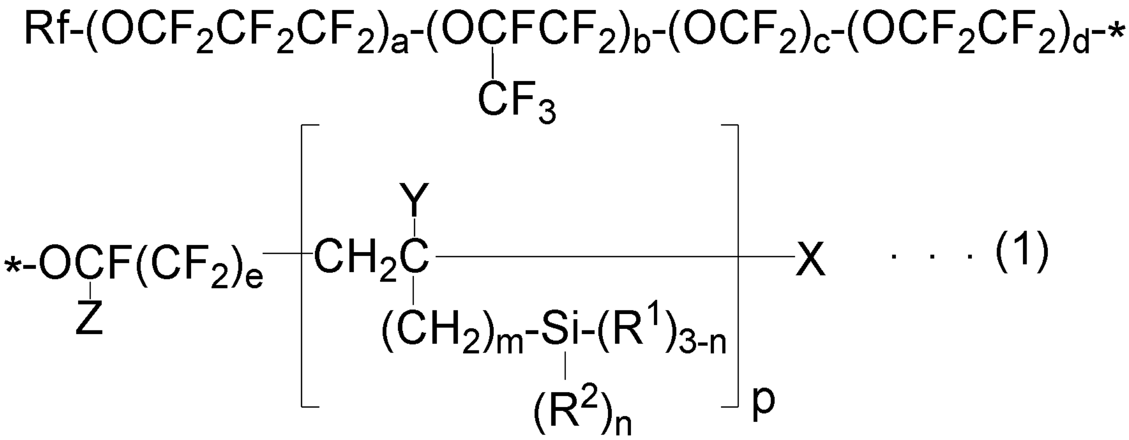

· · · (1)

In the general formula (1), Rf is a linear or branched perfluoroalkyl group having 1 to 16 carbon atoms, and preferably $CF_3$-, $C_2F_5$-, or $C_3F_7$-. $R_1$ is a hydrolyzable group, and preferably, for example, a halogen atom, $-OR_3$, $-OCOR_3$, $-OC(R_3)=C(R_4)_2$, $-ON=C(R_3)_2$, or $-ON=CR_5$. More preferably, Rf is a chlorine atom, $-OCH_3$, or $-OC_2H_5$. Here, $R^3$ is an aliphatic hydrocarbon group or an aromatic hydrocarbon group, $R^4$ is a hydrogen atom or an aliphatic hydrocarbon group (for example, a lower aliphatic hydrocarbon group), and $R^5$ is a divalent aliphatic hydrocarbon group having 3 to 6 carbon atoms. $R_2$ is a hydrogen atom or a monovalent organic group. The monovalent organic group is preferably an inert group. The monovalent organic group is more preferably a monovalent hydrocarbon group having 1 to 4 carbon atoms. X is an iodine atom or a hydrogen atom, and Y is a hydrogen atom or an alkyl group (for example, a lower alkyl group). Z is a fluorine atom or a trifluoromethyl group. a, b, c, and d are each independently an integer within the range of 0 to 200, and preferably an integer within the range of 1 to 50. e is 0 or 1. m and n are each independently an integer within the range of 0 to 2, and preferably 0. p is an integer of at least 1, and preferably an integer within the range of 1 to 10.

In addition, the molecular weight (weight average molecular weight Mw) of the fluorine-based organosilane compound represented by general formula (1) is not particularly limited, and may be, for example, within the range of $5 \times 10^2$ to $1 \times 10^5$ or the range of $5 \times 10^2$ to $1 \times 10^4$.

In addition, in one embodiment, the fluorine-containing organic silane compound represented by the general formula (1) may be a fluorine-containing organic silane compound represented by the following the general formula (2).

[C2]

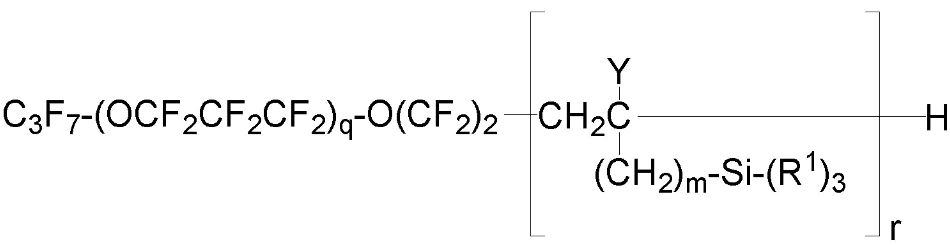

· · · (2)

$R_1$, Y, and m in the general formula (2) have the same meanings as in the general formula (1). q is an integer within the range of 1 to 50, and r is an integer within the range of 1 to 10.

The film thickness of the water-repellent layer is, for example, at most 30 nm, at most 25 nm, at most 20 nm, or at most 15 nm. The film thickness of the water-repellent layer is, for example, at least 5 nm or at least 10 nm. In addition, the contact angle with respect to water on the surface of the water-repellent layer is, for example, at least 100° and at most

120°.

In the above production method, at least one metal atom-containing layer may be formed at any position on either the object side or the eyeball side of the spectacle lens. For example, in the production method, a spectacle lens having the metal atom-containing layer between the inorganic layer and the water-repellent layer may be produced. In this case, a laminated body at least comprising the inorganic layer, the metal atom-containing layer, and the water-repellent layer may be formed on at least one surface of the base material or may be formed on both surfaces. For example, the laminate can be positioned on the object side of the spectacle lens, the laminated body can be positioned on the eyeball side of the spectacle lens, and the laminated bodies can be positioned on the object side and the eyeball side of the spectacle lens. When the laminate is positioned on both sides of the spectacle lens, the laminated body on the object side and the laminated body on the eyeball side can be the same laminated body or different laminated bodies.

In the spectacle lens, the metal atom-containing layer can function as an antibacterial layer and can thereby exhibit antibacterial properties. In addition, when the metal atom-containing layer has a water-repellent layer, the spectacle lens can exhibit water repellency, and thereby, for example, water discoloration of the lens and the like can be prevented. The inorganic layer functions, for example, as an antireflection film, and thus, a spectacle lens can have an antireflection property with respect to light having a specific wavelength or light within a specific wavelength range.

In the present disclosure, examples, contents, and various physical properties of the above components may be arbitrarily combined with matters described as examples or preferable ranges in the detailed description of the invention.

In addition, when the composition described in the examples is adjusted to the composition described in the detailed description of the invention, the invention can be carried out in the same manner as in the examples over the entire claimed scope of the composition.

## Examples

Hereinafter, the present disclosure will be further described with reference to Examples. However, the present disclosure is not limited to the embodiments shown in Examples.

In the following description, a $SiO_2$ layer is a vapor deposition film formed using silicon dioxide as a vapor deposition material, and the $ZrO_2$ layer is a vapor deposition film formed using zirconium (IV) oxide as a vapor deposition material. Each vapor deposition material is a vapor deposition material composed only of the oxide described if inevitably incorporated impurities are excluded.

### [Example 1]

<Preparation of Hard Coat Layer-Attached Lens Base Material>

A hard coat liquid containing inorganic oxide particles and a silicon compound was applied to the entire object-side surface (convex surface) of a plastic lens base material produced using a spectacle lens monomer (MR8 commercially available from Mitsui Chemicals, Inc.) by spin coating, and cured by heating in a heating furnace with an internal temperature of 100°C for 60 minutes to thereby form a single-layered hard coat layer having a film thickness of 3 μm.

<Production of Multilayer Antireflection Film>

Next, the lens base material with the hard coat layer formed thereon was put in a vacuum vapor deposition device, and a multilayer antireflection film in which a total of 7 layers including "$SiO_2$ layer / $ZrO_2$ layer / $SiO_2$ layer / $ZrO_2$ layer / $SiO_2$ layer / $ZrO_2$ layer / $SiO_2$ layer" (total thickness: about 400 to 600 nm) were laminated was formed on the entire hard coat layer surface by a vacuum deposition method. The notation "/" indicates that the part described on the left of "/" and the part described on the right thereof are directly laminated. This point also applies to the following description.

A spectacle lens with a layer structure of "lens base material / hard coat layer / multilayer antireflection film (inorganic layer; inorganic material content was at least 90% by mass)" was thus produced.

<Preparation of Metal Atom-Containing Layer>

(Preparation of Vapor Deposition Source)

As a first metal component solution, an aqueous dispersion containing silver particles with a particle size of 2 to 5 nm at a concentration of 5,000 ppm was prepared.

As a second metal particle-containing liquid, an aqueous dispersion containing platinum particles with a particle size of 2 to 5 nm at a concentration of 5,000 ppm was prepared.

As a carrier, a silicon dioxide granule ($SiO_2$ granule, D50: 1.0 mm) was used. Into this $SiO_2$ granule, 1.0 mL of a first metal particle-containing liquid was injected, and then a drying process was performed for one hour in an atmospheric oven at an internal temperature of 65°C to 75°C. This process was repeated twice (the total amount of the first metal particle-containing liquid injected into the carrier: 2.0 mL), then 1.0 mL of a second metal particle-containing liquid was injected, and then a drying process was performed for one hour in an atmospheric oven at an internal temperature of 65°C to 75°C. This process was repeated twice (the total amount of the second metal particle-containing liquid injected into the carrier: 2.0 mL) to prepare a vapor deposition source in which the $SiO_2$ granule carried silver particles and platinum particles (vapor deposition materials).

(Film-Formation of Metal Atom-Containing Layer by Electron Beam Vapor Deposition Method)

As illustrated in Fig. 1, the spectacle lens, on which multilayer anti-reflection film was formed, and the vapor deposition source were placed in the vacuum chamber of the vacuum vapor deposition device. The pressure in the vacuum chamber was set to at most $2 \times 10^{-2}$ Pa, and the vapor deposition source was irradiated with an electron beam emitted from an electron gun toward the vapor deposition source at the following electron beam irradiation condition: electron beam output (heating current) of 38 mA and an electron beam irradiation time of 300 seconds. This electron beam irradiation can heat and vaporize silver particles and platinum particles and form a vapor deposition film in which silver particles and platinum particles are deposited on the surface of the multilayer anti-reflection film. Thus, a metal atom-containing layer (metal-containing inorganic layer, metals contained: silver and platinum, inorganic substance content: at least 90% by mass, thickness: 3 nm) was formed on the surface of the multilayer anti-reflection film.

<Preparation of Water-Repellent Layer>

(Preparation of Vapor Deposition Source)

A liquid containing m-xylene hexafluoride as a fluorine-based substance was prepared.

As a carrier, a disc-shaped sintered filter (material: SUS) with a diameter of 18 mm was used. To this sintered filter, 0.25 mL of the above liquid was injected, and the sintered filter was subjected to a drying process for one hour in an atmospheric oven at an internal temperature of 50°C.

Thus, a vapor deposition source in which the sintered filter carried m-xylene hexafluoride (vapor deposition material) was prepared.

(Deposition of Water-Repellent Layer by Heat Vapor Deposition Method)

As illustrated in Fig. 1, the spectacle lens, on which the metal atom-containing layer was formed, and the vapor deposition source were placed in the vacuum chamber of the vacuum vapor deposition device.

A water-repellent layer was formed by a heating vapor deposition method in the manner wherein the electron gun in Fig. 1 was replaced with a halogen heater, the internal atmosphere temperature in the vacuum chamber was controlled to 650°C by the halogen heater, and the pressure in the vacuum chamber was controlled to at most $2 \times 10^{-2}$ Pa. Heating the interior of the chamber as such could heat and vaporize m-xylene hexafluoride and form a vapor deposition film in which m-xylene hexafluoride was deposited on the surface of the metal atom-containing layer. As such, a water-repellent layer (water-repellent agent: m-xylene hexafluoride) with a film thickness of 10 to 20 nm was formed on the metal atom-containing layer. The contact angle of the water-repellent layer was 110°.

According to the above steps, a spectacle lens of Example 1 having a layer structure of "lens base material / hard coat layer (thickness: 3 μm) / multilayer antireflection film (inorganic layer) (thickness: 400 to 600 nm) / metal atom-containing layer (thickness: 3 nm) / water-repellent layer (fluorine-based organic layer, organic substance content: at least 90% by mass, thickness: 10 to 20 nm)" was prepared.

[Comparative Example 1]

A spectacle lens of Comparative Example 1 having a layer structure of "lens base material / hard coat layer (thickness: 3 μm) / multilayer antireflection film (inorganic layer) (thickness: 400 to 600 nm) / water-repellent layer (thickness: 10 to 20 nm)" was prepared in the same manner as in Example 1, except that the metal atom-containing layer was not formed.

[Comparative Example 2]

<Preparation of Hard Coat Layer-Attached Lens Base Material>

A hard coat liquid containing inorganic oxide particles and a silicon compound was applied to the entire object-side surface (convex surface) of a plastic lens base material produced using a spectacle lens monomer (MR8 manufactured by Mitsui Chemicals, Inc.) by spin coating, and cured by heating in a heating furnace with an internal temperature of 100°C for 60 minutes to thereby form a single-layered hard coat layer having a film thickness of 3 um.

<Preparation of Multilayer Antireflection Film>

Next, the lens base material with the hard coat layer formed thereon was put in a vacuum vapor deposition device, and a multilayer antireflection film in which a total of 7 layers including "($SiO_2$+Ag) layer / $ZrO_2$ layer / ($SiO_2$+Ag) layer / $ZrO_2$ layer / ($SiO_2$+Ag) layer / $ZrO_2$ layer / $SiO_2$+Ag) layer" (total thickness: about 400 to 600 nm) were laminated was formed on the entire hard coat layer surface by a vacuum vapor deposition method. The ($SiO_2$+Ag) layer was formed using silicon dioxide ($SiO_2$) and metal ion-carrying zeolite (trade name: AG-H3, manufactured by Kisan Kinzoku Chemicals Co., Ltd.) .

A spectacle lens with a layer structure of "lens base material / hard coat layer / multilayer antireflection film (inorganic layer; inorganic material content was at least 90% by mass)" was thus produced.

<Preparation of Water-Repellent Layer>

(Preparation of Vapor Deposition Source)

A liquid containing m-xylene hexafluoride as a fluorine-based substance was prepared.

As a carrier, a disc-shaped sintered filter (material: SUS) with a diameter of 18 mm was used. To this sintered filter, 0.25 mL of the above liquid was injected, and the sintered filter was subjected to a drying process for one hour in an atmospheric oven at an internal temperature of 50°C.

Thus, a vapor deposition source in which the sintered filter carried m-xylene hexafluoride (vapor deposition material) was prepared.

(Formation of Water-repellent Layer by Heat Deposition Method)

As illustrated in Fig. 1, the spectacle lens, on which multilayer anti-reflection film was formed, and the vapor deposition source were placed in the vacuum chamber of the vacuum vapor deposition device.

A water-repellent layer was formed by a heating vapor deposition method in the manner wherein the electron gun in Fig. 1 was replaced with a halogen heater, the internal atmosphere temperature in the vacuum chamber was controlled to 650°C by the halogen heater, and the pressure in the vacuum chamber was controlled to at most $2 \times 10^{-2}$ Pa. Heating the interior of the chamber as such could heat and vaporize m-xylene hexafluoride and form a vapor deposition film in which m-xylene hexafluoride was deposited on the surface of the multilayer anti-reflection film. As such, a water-repellent layer (water-repellent agent: m-xylene hexafluoride) with a film thickness of 10 to 20 nm was formed on the multilayer anti-reflection film.

According to the above steps, a spectacle lens of Comparative Example 2 having a layer structure of "lens base material / hard coat layer (thickness: 3 μm) / multilayer antireflection film (inorganic layer) (thickness: 400 to 600 nm) / water-repellent layer (fluorine-based organic layer, organic substance content: at least 90% by mass, thickness: 10 to 20 nm)" was prepared.

[Comparative Example 3]

A spectacle lens of Comparative Example 3 having a layer structure of "lens base material / hard coat layer (thickness: 3 μm) / multilayer antireflection film (inorganic layer) (thickness 400 to 600 nm) / metal atom-containing layer (thickness: 3 nm) / water-repellent layer (thickness: 10 to 20 nm)" was prepared in the same manner as in Example 1, except that the preparation of the vapor deposition source in the preparation of the metal atom-containing layer was performed in the manner described below.

(Preparation of Vapor Deposition Source)

As a first metal particle-containing liquid, an aqueous dispersion containing silver particles with a particle size of 2 to 5 nm at a concentration of 5,000 ppm was prepared.

As a second metal particle-containing liquid, an aqueous dispersion containing platinum particles with a particle size of 2 to 5 nm at a concentration of 5,000 ppm was prepared.

As a carrier, a disc-shaped sintered filter (material: SUS) with a diameter of 18 mm was used. Into this sintered filter, 0.5 mL of a first metal particle-containing liquid was injected, and then a drying process was performed for one hour in an atmospheric oven at an internal temperature of 65°C to 75°C. This process was repeated twice (the total amount of the first metal particle-containing liquid injected into the carrier: 1.0 mL), then 0.5 mL of a second metal particle-containing liquid was injected, and then a drying process was performed for one hour in an atmospheric oven at an internal temperature of 65°C to 75°C. This process was repeated twice (the total amount of the second metal particle-containing liquid injected into the carrier: 1.0 mL) to prepare a vapor deposition source in which the sintered filter carried silver particles and platinum particles (vapor deposition materials).

[Evaluation of Reflection Properties and Transmission Properties]

The direct incident reflection spectral properties at an optical center of the object side surface (convex surface side) were measured from the object side of spectacle lenses of Example 1 and Comparative Examples 1 to 3.

The direct incident reflection spectral properties at an optical center of the eyeball side surface (concave surface side) were also measured from the eyeball side of spectacle lenses of Example 1 and Comparative Examples 1 to 3.

The spectral shapes of the transmission spectrum, the reflection spectrum on the convex surface side, and the reflection spectrum on the concave surface side of Example 1 at a wavelength of 380 to 780 nm, obtained from the measurement results, were substantially coincident with the spectral shapes of respective spectra of Comparative Example 1.

The luminous reflectance was determined according to JIS T 7334:2011, and the luminous transmittance was determined according to JIS T 7333: 2005. Table 1 shows the results.

[Table 1]

Table 1

| | Luminous reflectance (on convex surface side) | Luminous reflectance (on concave surface side) | Luminous transmittance |
|---|---|---|---|
| Example 1 | 0.65% | 0.65% | 98.2% |
| Comparative Example 1 | 0.51% | 0.49% | 98.5% |
| Comparative Example 2 | 1.09% | 1.09% | 97.8% |
| Comparative Example 3 | 0.50% | 0.47% | 98.5% |

From the result shown in Table 1, it is found that the metal atom-containing layer had little effect on the reflection properties and the transmission properties of spectacle lenses in the spectacle lens of Example 1.

The presence of metal particles was confirmed by cross-sectional observation of each spectacle lens of Example 1 using SEM.

[Antibacterial Tests]

The antibacterial test was performed on spectacle lenses of Example 1 and Comparative Examples 1 to 3 according to JIS Z 2801:2012.

Specifically, three test specimens are cut out from each spectacle lens for initial evaluation of antibacterial properties, water resistance evaluation, and light resistance evaluation. The size of the test sample is set to 50 mm × 50 mm.

Initial evaluation is performed in the following manner.

A test specimen cut out from each spectacle lens is put in a sterile petri dish with the surface of the side with the lamination of the various layers described above facing upward. Then, 0.4 mL of a bacterial solution containing $1.0 \times 10^5$ to $4.0 \times 10^5$ test bacteria (Staphylococcus aureus or Escherichia coli) is added dropwise onto the center of the surface of the test specimen, and the test specimen is covered with a polyethylene film cut into a 40 mm × 40 mm piece. After this petri dish is placed in an environment at a relative humidity of at least 90% for 24 hours, a viable cell count per $cm^2$ is measured.

The water resistance is evaluated in the following manner.

A water resistance test of classification 1 described in the water resistance test chapter of the persistence test method (published in 2018) by The Society of International sustaining growth for Antimicrobial Articles (SIAA) is performed on a test piece cut out from each spectacle lens, and the viable bacteria count is measured by the following method.
The light resistance is evaluated in the following manner.
A light resistance test of classification 1 described in the water resistance test chapter of the persistence test method (published in 2018) by The Society of International sustaining growth for Antimicrobial Articles (SIAA) is performed on a test piece cut out from each spectacle lens, and the viable bacteria count is measured by the following method.
Table 2 shows the viable bacteria count measured in various evaluations described above in Comparative Example 1.

[Table 2]

Table 2

| Evaluation | | Viable bacteria count |
|---|---|---|
| Staphylococcus aureus | Initial Evaluation | $1 \times 10^{3.95}$ |
| | Water resistance evaluation | $1 \times 10^{4.17}$ |
| | Light resistance evaluation | $1 \times 10^{3.99}$ |
| Escherichia coli | Initial Evaluation | $1 \times 10^{5.95}$ |
| | Water resistance evaluation | $1 \times 10^{6.05}$ |
| | Light resistance evaluation | $1 \times 10^{6.04}$ |

An antibacterial activity value was determined on Example 1 based on the formula below from the viable bacteria count measured in the various evaluations described above.
An antibacterial activity value was determined on Comparative Example 3 based on the formula below from the viable bacteria count measured in the various evaluations described above.

$$\text{Antibacterial activity value} = Ut - At$$

Ut: The logarithmic value of the viable bacteria count on the sample piece of Comparative Example 1
At: The logarithmic value of the viable bacteria count on the sample piece of Example 1 or Comparative Example 3

Table 3 shows the evaluation result of Example 1, and Table 4 shows the evaluation result of the Comparative Example 3.

[Table 3]

Table 3

| Evaluation | | Antibacterial activity value |
|---|---|---|
| Staphylococcus aureus | Initial Evaluation | More than 2.0 |
| | Water resistance evaluation | More than 2.0 |
| | Light resistance evaluation | More than 2.0 |
| Escherichia coli | Initial Evaluation | More than 2.0 |
| | Water resistance evaluation | More than 2.0 |
| | Light resistance evaluation | More than 2.0 |

[Table 4]

Table 4

| Evaluation | | Antibacterial activity value |
|---|---|---|
| Staphylococcus aureus | Initial Evaluation | More than 2.0 |
| | Water resistance evaluation | More than 2.0 |
| | Light resistance evaluation | More than 2.0 |
| Escherichia coli | Initial Evaluation | More than 2.0 |
| | Water resistance evaluation | More than 2.0 |
| | Light resistance evaluation | More than 2.0 |

As stated above, it is found from the results of Examples and Comparative Examples that the method for producing a spectacle lens according to the Examples can produce a spectacle lens with no adverse effects on reflective and transmissive characteristics and high antimicrobial performance.

Finally, the embodiments of the present disclosure are summarized.

The method for producing a spectacle lens according to an embodiment of the present disclosure is a method for producing a spectacle lens with a base material and a metal atom-containing layer disposed on the base material, the method including forming the metal atom-containing layer on the base material by electron beam vapor deposition of irradiating, with an electron beam, a vapor deposition source provided with a carrier that contains at least one granule selected from the group consisting of silicon dioxide ($SiO_2$), zirconium oxide (IV) ($ZrO_2$), and titanium oxide (IV) ($TiO_2$) and carries a metal particle containing at least one metal.

According to the embodiments described above, a method for producing a spectacle lens capable of producing a spectacle lens with no adverse effects on reflective and transmissive characteristics and high antimicrobial performance can be provided.

The embodiments disclosed here are only illustrative in all respects and should not be considered as restrictive. The scope of the present disclosure is indicated by the scope of the claims rather than the above description, and is intended to include meanings equivalent to the scope of the claims and all modifications within the scope of the claims.

In the present disclosure, examples, contents, and various physical properties of the above components may be arbitrarily combined with matters described as examples or preferable ranges in the detailed description of the invention.

In addition, if the compositions described in the examples are adjusted to compositions described in the detailed description of the invention, the disclosed embodiments can be implemented in the same manner as in examples over the entire claimed composition range. Reference Signs List

1 Vacuum vapor deposition device
2 Vapor deposition source
3 Electron gun
11 Object to be deposited
14 Metal atom-containing layer
EB Electron beam

**Claims**

1. A method for producing a spectacle lens with a base material and a metal atom-containing layer disposed on the base material, the method comprising:
forming the metal atom-containing layer on the base material by electron beam vapor deposition of irradiating, with an electron beam, a vapor deposition source provided with a carrier that contains at least one granule selected from the group consisting of silicon dioxide ($SiO_2$), zirconium oxide (IV) ($ZrO_2$), and titanium oxide (IV) ($TiO_2$) and carries a metal particle containing at least one metal.

2. The method for producing a spectacle lens according to claim 1, wherein
the average particle diameter D50 of the granule is 0.1 to 5.0 mm.

3. The method for producing a spectacle lens according to claim 1 or 2, wherein the granule is composed only of silicon dioxide ($SiO_2$).

4. The method for producing a spectacle lens according to any one of claims 1 to 3, wherein the metal particle includes silver.

5. The method for producing a spectacle lens according to any one of claims 1 to 4, wherein the metal particle contains at least one selected from the group consisting of platinum, gold, palladium, mercury, cadmium, cobalt, nickel, copper, zinc, titanium, molybdenum, and tungsten.

6. The method for producing a spectacle lens according to any one of claims 1 to 5, further comprising: impregnating the carrier with a liquid containing the metal particle and drying the carrier so that the carrier carries the metal particle.

7. The method for producing a spectacle lens according to any one of claims 1 to 6, wherein

   the spectacle lens further has an anti-reflection film disposed on the base material, and
   the metal atom-containing layer is disposed on the anti-reflection film.

8. The method for producing a spectacle lens according to any one of claims 1 to 6, wherein

   the spectacle lens further has an anti-reflection film disposed on the base material,
   the anti-reflection film is a laminated body with a lamination of a plurality of single layers, and
   the metal atom-containing layer is disposed between at least one pair of the single layers adjacent to each other.

9. The method for producing a spectacle lens according to any one of claims 1 to 8, wherein the film thickness of the metal atom-containing layer is at most 5 nm.

[Fig. 1]

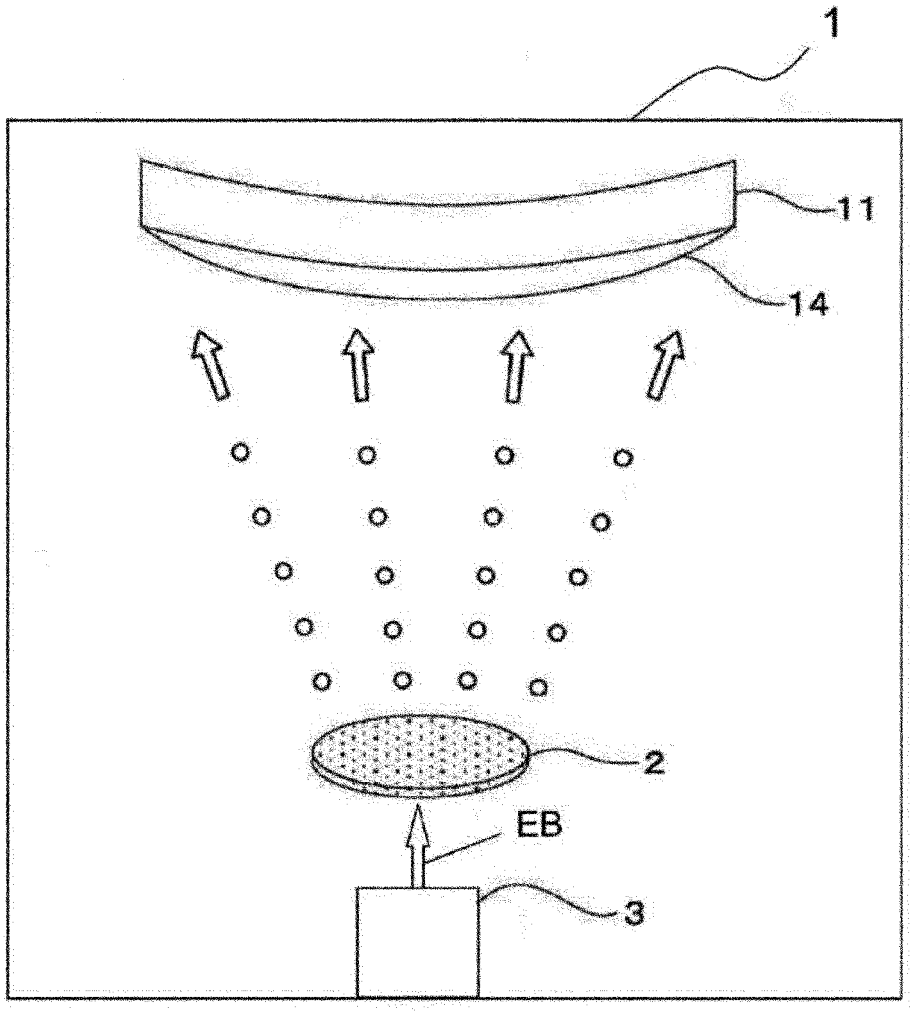

**INTERNATIONAL SEARCH REPORT**

International application No.
**PCT/JP2023/007736**

**A. CLASSIFICATION OF SUBJECT MATTER**

***G02B 1/18***(2015.01)i; ***C23C 14/10***(2006.01)i; ***G02B 1/115***(2015.01)i; ***G02C 7/10***(2006.01)i
FI: G02B1/18; C23C14/10; G02B1/115; G02C7/10

According to International Patent Classification (IPC) or to both national classification and IPC

**B. FIELDS SEARCHED**

Minimum documentation searched (classification system followed by classification symbols)

G02B1/18; C23C14/10; G02B1/115; G02C7/10

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2021-56327 A (HOYA LENS THAILAND LTD) 08 April 2021 (2021-04-08) entire text, all drawings | 1-9 |
| A | JP 2018-12877 A (KISAN KINZOKU KK) 25 January 2018 (2018-01-25) entire text, all drawings | 1-9 |
| A | JP 2020-142494 A (ITO OPTICAL IND CO LTD) 10 September 2020 (2020-09-10) entire text, all drawings | 1-9 |
| A | JP 2018-159860 A (TOKAI KOGAKU KK) 11 October 2018 (2018-10-11) entire text, all drawings | 1-9 |
| A | JP 2006-184849 A (TOPPAN PRINTING CO LTD) 13 July 2006 (2006-07-13) entire text, all drawings | 1-9 |
| A | JP 3-126865 A (TOSHIBA CORP) 30 May 1991 (1991-05-30) entire text, all drawings | 1-9 |
| P, A | WO 2022/097752 A1 (HOYA LENS THAILAND LTD) 12 May 2022 (2022-05-12) entire text, all drawings | 1-9 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **03 April 2023** | **18 April 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**

International application No.
**PCT/JP2023/007736**

**C. DOCUMENTS CONSIDERED TO BE RELEVANT**

| Category* | Citation of document, with indication, where appropriate, of the relevant passages | Relevant to claim No. |
|---|---|---|
| P, A | WO 2022/097751 A1 (HOYA LENS THAILAND LTD) 12 May 2022 (2022-05-12) entire text, all drawings | 1-9 |

Form PCT/ISA/210 (second sheet) (January 2015)

**INTERNATIONAL SEARCH REPORT**
**Information on patent family members**

International application No.
**PCT/JP2023/007736**

| Patent document cited in search report | Publication date (day/month/year) | Patent family member(s) | Publication date (day/month/year) |
|---|---|---|---|
| JP 2021-56327 A | 08 April 2021 | US 2022/0214562 A1<br>entire text, all drawings<br>WO 2021/060554 A1<br>EP 4036632 A1<br>KR 10-2022-0044825 A<br>CN 114467042 A | |
| JP 2018-12877 A | 25 January 2018 | (Family: none) | |
| JP 2020-142494 A | 10 September 2020 | (Family: none) | |
| JP 2018-159860 A | 11 October 2018 | (Family: none) | |
| JP 2006-184849 A | 13 July 2006 | (Family: none) | |
| JP 3-126865 A | 30 May 1991 | (Family: none) | |
| WO 2022/097752 A1 | 12 May 2022 | JP 2022-76442 A | |
| WO 2022/097751 A1 | 12 May 2022 | JP 2022-76441 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2018012877 A